# EUROPEAN PATENT APPLICATION

(11) **EP 4 656 769 A1**
(43) Date of publication of application: **03.12.2025**
(21) Application number: 24747200.4
(22) Date of filing: 18.01.2024
(51) Int. Cl.: C23C 16/448, H01L 21/31, H01L 21/368

(54) **FILM-FORMING AUXILIARY AGENT FOR CHEMICAL VAPOR DEPOSITION, COATING SOLUTION FOR CHEMICAL VAPOR DEPOSITION, METAL OXIDE FILM, AND FILM-FORMING METHOD FOR METAL OXIDE FILM**

(30) Priority: 24.01.2023 JP 2023008576
(71) Applicant: NOF Corporation, Tokyo 150-6012 (JP)
(72) Inventor: SATO,Kyohei, Tsukuba-shi, Ibaraki 300-2635 (JP); FUJIMURA,Toshinobu, Tsukuba-shi, Ibaraki 300-2635 (JP); NAKASATO,Katsumi, Tsukuba-shi, Ibaraki 300-2635 (JP); IIZUKA,Muneaki, Tsukuba-shi, Ibaraki 300-2635 (JP)
(74) Representative: Hoffmann Eitle
(86) International application number: PCT/JP2024/001261
(87) International publication number: WO 2024/157871

(57) **Abstract**

Provided is a film-forming auxiliary agent for chemical vapor deposition which contains a compound represented by general formula (1): R¹R²NCONH₂ (in the formula, R¹ and R² each independently represent a hydrogen atom, a hydrocarbon group having 1 to 22 carbon atoms, an amino group, or a hydroxyl group.). The film-forming auxiliary agent for chemical vapor deposition makes it possible to obtain a metal oxide film having low surface roughness while having an excellent effect of increasing the film-forming rate.

## Description

### TECHNICAL FIELD

The present invention relates to a film-forming auxiliary agent for chemical vapor deposition, a coating solution for chemical vapor deposition, a metal oxide film, and a film-forming method for a metal oxide film.

### BACKGROUND ART

Chemical vapor deposition (CVD) is a film-forming method performed by reactions of raw materials in the vapor phase and chemical reactions on substrates. CVD does not require a high vacuum and is suitable for mass production. Plasma CVD, atomic layer deposition (ALD), metal organic CVD, and the like are known.

As another CVD technique, mist CVD is known as a film-forming method in which a solution containing metal atoms is converted into mist of droplets having a particle size of 500 µm or less by ultrasonic waves or the like, and the mist is reacted on a substrate heated to 500°C or less to form a metal oxide (for example, Patent Documents 1 to 3). Mist CVD is a particularly preferred film-forming method since a film can be formed under atmospheric pressure, mist that is micronized solution is used, and a uniform and dense film can be formed on a substrate.

### PRIOR ART DOCUMENT

### PATENT DOCUMENTS

Patent Document 1: JP-A-2018-140352
Patent Document 2: JP-A-2018-172793
Patent Document 3: WO 2011/027425

### SUMMARY OF THE INVENTION

### PROBLEMS TO BE SOLVED BY THE INVENTION

A number of film formations of metal oxide films using mist CVD have been investigated so far, but film formation at high temperatures and a method in which conveyed mist is heated have been investigated in order to obtain an industrially satisfactory film-forming rate, but the film-forming rate is still not satisfactory.

Patent Document 3 discloses a film-forming method in which a solution of a metal salt or complex containing a metal element and ethylenediamine as a film-forming auxiliary agent is converted into mist and then the mist is supplied to a heated substrate to form a metal oxide film on the substrate. In the course of investigating the film formation of low-resistance metal oxide films by adding film-forming auxiliary agents, improvement in film-forming rate has been observed but the film-forming rate is still not sufficient. Furthermore, as the film-forming rate increases, the surface roughness of the film increases, and there is a risk that the surface roughness becomes poor. Therefore, there has been a demand for an excellent method for increasing the film-forming rate as well as preventing the surface roughness of the film from becoming poor.

The present invention has been made in view of the above-mentioned circumstances, and an object thereof is to provide a film-forming auxiliary agent for chemical vapor deposition, which has an excellent film-forming rate improving effect as well as affords a metal oxide film having a low surface roughness.

Another object of the present invention is to provide a coating solution for chemical vapor deposition containing the film-forming auxiliary agent for chemical vapor deposition, a metal oxide film formed from the coating solution, and a film-forming method for the metal oxide film.

### MEANS FOR SOLVING THE PROBLEMS

The present invention relates to a film-forming auxiliary agent for chemical vapor deposition, which contains a compound represented by general formula (1): R¹R²NCONH₂ (in the formula, R¹ and R² each independently represent a hydrogen atom, a hydrocarbon group having 1 to 22 carbon atoms, an amino group, or a hydroxyl group).

The present invention also relates to a coating solution for chemical vapor deposition, which contains a solution of the film-forming auxiliary agent for chemical vapor deposition and a solution of a metal salt or complex.

The present invention also relates to a metal oxide film having a thickness of 0.1 µm or more and 20 µm or less, which is formed from a solution of the film-forming auxiliary agent for chemical vapor deposition and a solution of a metal salt or complex.

The present invention also relates to a film-forming method for a metal oxide film, which includes a step (a1) of separately converting a solution of the film-forming auxiliary agent for chemical vapor deposition into mist and a solution of a metal salt or complex into mist; and a step (b1) of simultaneously supplying each mist to a heated substrate surface.

The present invention also relates to a film-forming method for a metal oxide film, which includes a step (a2) of converting the coating solution for chemical vapor deposition into mist and a step (b2) of supplying the obtained mist to a heated substrate surface.

### EFFECT OF THE INVENTION

As the film-forming auxiliary agent for chemical vapor deposition of the present invention contains a compound represented by general formula (1): R¹R²NCONH₂ (in the formula, R¹ and R² each independently represent a hydrogen atom, a hydrocarbon group having 1 to 22 carbon atoms, an amino group, or a hydroxyl group), formation of a metal oxide film is promoted, and a metal oxide film having a low surface roughness is obtained as well as the film-forming rate is high.

### BRIEF DESCRIPTION OF THE DRAWINGS

Fig. 1 is a schematic view of a film-forming apparatus for a metal oxide film in a method for manufacturing a metal oxide film according to an embodiment of the present invention.
Fig. 2 is a schematic view of a film-forming apparatus for a metal oxide film in a method for manufacturing a metal oxide film according to an embodiment of the present invention.
Fig. 3 is a schematic view of an atomizer in a film-forming apparatus for a metal oxide film in a method for manufacturing a metal oxide film according to an embodiment of the present invention.
Fig. 4 is a schematic view of a mixing chamber in a film-forming apparatus for a metal oxide film in a method for manufacturing a metal oxide film according to an embodiment of the present invention.
Fig. 5 is a schematic view of a film-forming unit in a film-forming apparatus for a metal oxide film in a method for manufacturing a metal oxide film according to an embodiment of the present invention.

### MODE FOR CARRYING OUT THE INVENTION

Hereinafter, a film-forming auxiliary agent for chemical vapor deposition, a coating solution for chemical vapor deposition, a metal oxide film, and a film-forming method for a metal oxide film according to an embodiment of the present invention will be described with reference to figures, if necessary.

### <Film-forming auxiliary agent for chemical vapor deposition>

The film-forming auxiliary agent for chemical vapor deposition (hereinafter also referred to as "film-forming auxiliary agent for CVD") contains a compound represented by general formula (1): R¹R²NCONH₂ (in the formula, R¹ and R² each independently represent a hydrogen atom, a hydrocarbon group having 1 to 22 carbon atoms, an amino group, or a hydroxyl group).

In general formula (1), R¹ and R² are preferably each independently a hydrogen atom from the viewpoints of improving the film-forming rate and reducing the surface roughness. Examples of the hydrocarbon group include a linear alkyl group, a branched alkyl group, and an aralkyl group, and among these, a linear alkyl group and a branched alkyl group are preferable from the viewpoint of improving the film-forming rate. The number of carbon atoms is preferably 1 to 10, still more preferably 1 to 5 from the viewpoint of improving the film-forming rate. Among these, it is particularly preferable that R¹ and R² are both hydrogen atoms. It is also possible to use a clathrate compound included with hydrogen peroxide or the like.

### <Solution of film-forming auxiliary agent for chemical vapor deposition>

The film-forming auxiliary agent for chemical vapor deposition is preferably a solution of the film-forming auxiliary agent for chemical vapor deposition, which contains the compound represented by general formula (1) and a solvent, from the viewpoint of mist generation efficiency. The solvent may be any solvent as long as it can dissolve the compound represented by general formula (1), but from the viewpoint of mist generation efficiency, a solvent having a boiling point of 40°C or more and 150°C or less and a viscosity of 1.3 mPa·sec or less at 25°C is preferable, a solvent having a viscosity of 0.1 mPa·sec or more and 1.0 mPa·sec or less is more preferable, and a solvent having a viscosity of 0.5 mPa·sec or more and 1.0 mPa·sec or less is still more preferable. Examples of the solvent include polar solvents such as lower alcohols such as methanol, nitrile-based solvents such as acetonitrile, and water and non-polar solvents such as aromatic solvents such as toluene. These solvents may be used in mixture of two or more kinds thereof. Among these solvents, polar solvents are preferable, and lower alcohols and water are more preferable from the viewpoint of fully achieving the effects of the present invention by the action as an oxidation source. Furthermore, it is preferable to contain water from the viewpoint of easy handling properties and of being able to prevent the atomized coating solution from catching fire. Here, the oxidation source refers to a supply source of oxygen atoms for converting a metal salt or complex to be described later into a metal oxide.

In a case of using the solvent, the compound represented by general formula (1) is usually contained in the film-forming auxiliary agent for chemical vapor deposition at preferably 0.1% by weight or more and 20% by weight or less, more preferably 0.5% by weight or more and 10% by weight or less.

### <Metal salt or metal complex>

The metal element constituting the metal salt or metal complex may be any metal element as long as it can be formed into an oxide film by chemical vapor deposition, but the metal element is preferably one or more metal elements selected from Group 13 elements, Group 14 elements, or transition metal elements. Examples of Group 13 elements include Al, Ga, and In, examples of Group 14 elements include Si, Ge, Sn, and Pb, and examples of transition metal elements include D-block elements. As the metal element, Al, Si, Zr and Y are more preferable from the viewpoint of easy availability.

The salt or complex of the metal element may be any salt or complex as long as it can be formed into an oxide film by chemical vapor deposition, but examples thereof include metal salts or complexes such as aluminum tris(acetylacetonate), polysilazane, zirconium tetra(acetylacetonate), and yttrium(acetylacetonate).

### <Solution of metal salt or metal complex>

From the viewpoint of mist generation efficiency, the metal salt or complex is preferably a solution of the metal salt or complex containing the metal salt or complex and a solvent. The solvent may be any solvent as long as it can dissolve a compound that is a metal salt or a complex, but is preferably a solvent having a boiling point of 40°C or more and 150°C or less, more preferably a solvent having a boiling point of 50°C or more and 125°C or less from the viewpoint of mist generation efficiency. A solvent having a viscosity of 1.3 mPa·sec or less at 25°C is preferable, a solvent having a viscosity of 0.1 mPa·sec or more and 1.0 mPa·sec or less is more preferable, and a solvent having a viscosity of 0.2 mPa·sec or more and 0.8 mPa·sec or less is still more preferable. Examples of the solvent include polar solvents such as lower alcohols such as methanol, nitrile-based solvents such as acetonitrile, and water and non-polar solvents such as aromatic solvents such as toluene. These solvents may be used in mixture of two or more kinds thereof. In a case where the solution of the film-forming auxiliary agent for chemical vapor deposition does not contain a solvent that acts as an oxidation source, lower alcohols and water are more preferable as a solvent for the metal salt or complex from the viewpoint that the effects of the present invention can be more fully achieved. In a case of using a non-polar solvent, a miscible lower alcohol may be used, or only water may be used by being converted into mist and introduced into the mixer.

The solution of the metal salt or complex contains the metal salt or complex and the solvent, and the metal salt or complex is preferably contained at 0.2% by weight or more and 20% by weight or less. The film-forming rate decreases when the metal salt or complex is contained at less than 0.2% by weight, and the surface roughness of the metal oxide layer may increase when the metal salt or complex is contained at more than 20% by weight.

### <Coating solution for chemical vapor deposition>

The coating solution for chemical vapor deposition contains a solution of the film-forming auxiliary agent for chemical vapor deposition and a solution of then metal salt or complex. The coating solution for chemical vapor deposition may contain the film-forming auxiliary agent for chemical vapor deposition, the metal salt or complex, and a solvent for each of these.

### <Film-forming method for metal oxide film>

The method for forming a metal oxide film may be a chemical vapor deposition, and is preferably mist chemical vapor deposition (hereinafter also referred to as "mCVD") from the viewpoint of excellent film-forming rate and excellent film formation uniformity.

Examples of mCVD include a film-forming method for a metal oxide film, which includes a step (a1) of separately converting a solution of the film-forming auxiliary agent for chemical vapor deposition into mist and a solution of the metal salt or complex into mist; and a step (b1) of simultaneously supplying each mist to a heated substrate surface, and a film-forming method for a metal oxide film, which includes a step (a2) of converting the coating solution for chemical vapor deposition into mist and a step (b2) of supplying the obtained mist to a heated substrate surface. More specifically, fine particles obtained by converting the raw materials into mist are supplied to the surface of a substrate by a carrier gas, and then the fine particles are reacted in an atmosphere having a temperature of 200°C or more and 500°C or less. By reacting the raw materials in the form of fine particles, a metal oxide film having a high film-forming rate and a low surface roughness is obtained.

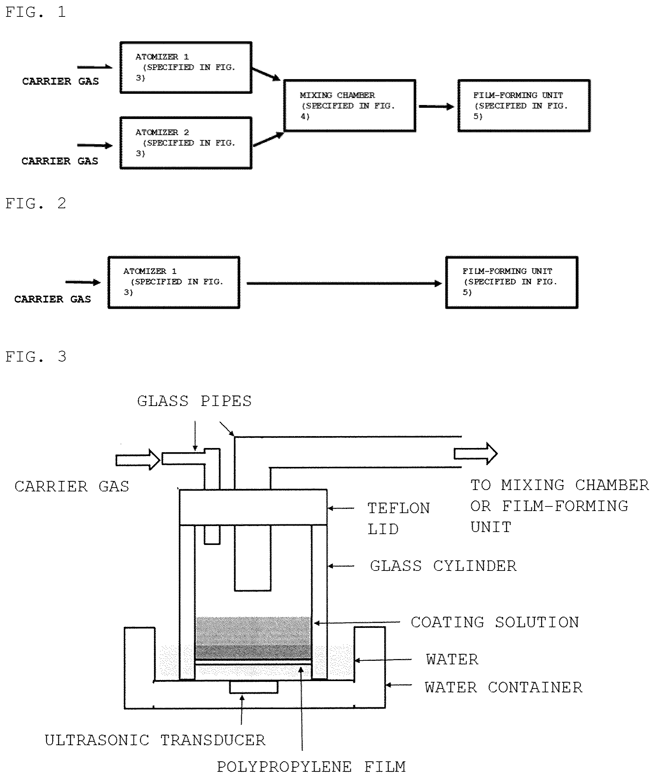

Fig. 1 illustrates a schematic view of a film-forming apparatus (1) in a film-forming method for a metal oxide film, which includes a step (a1) of separately converting a solution of the film-forming auxiliary agent for chemical vapor deposition into mist and a solution of the metal salt or complex into mist. The film-forming apparatus (1) includes two atomizers (mist generators), a mixing chamber, and a film-forming machine (film-forming unit) connected with pipes.

Fig. 2 illustrates a schematic view of a film-forming apparatus (2) in a film-forming method for a metal oxide film, which includes a step (a2) of converting the coating solution for chemical vapor deposition into mist and a step (b2) of supplying the obtained mist to a heated substrate surface. The film-forming apparatus (2) includes one atomizer (mist generator) and a film-forming machine (film-forming unit) connected with pipes.

Fig. 3 illustrates a schematic view of a mist generator in a film-forming apparatus for a metal oxide film. The mist generator includes a vessel for containing a raw material and an ultrasonic generator equipped with an ultrasonic transducer. The vessel includes a glass cylinder, a Teflon (registered trademark) lid, and a bottom made of a polypropylene or tetrafluoroethylene-hexafluoropropylene copolymer film. The lid is provided with two glass pipes penetrating therethrough. The first pipe is provided for sending a carrier gas (nitrogen) for conveying the mist into the vessel, and the second pipe is provided for sending the mist generated in the vessel and the carrier gas to the film-forming machine. The vessel is placed in the ultrasonic generator together with water, and the ultrasonic wave generated by the ultrasonic transducer is transmitted to the raw material via water and the film made of polypropylene or the like, whereby the raw material is converted into mist.

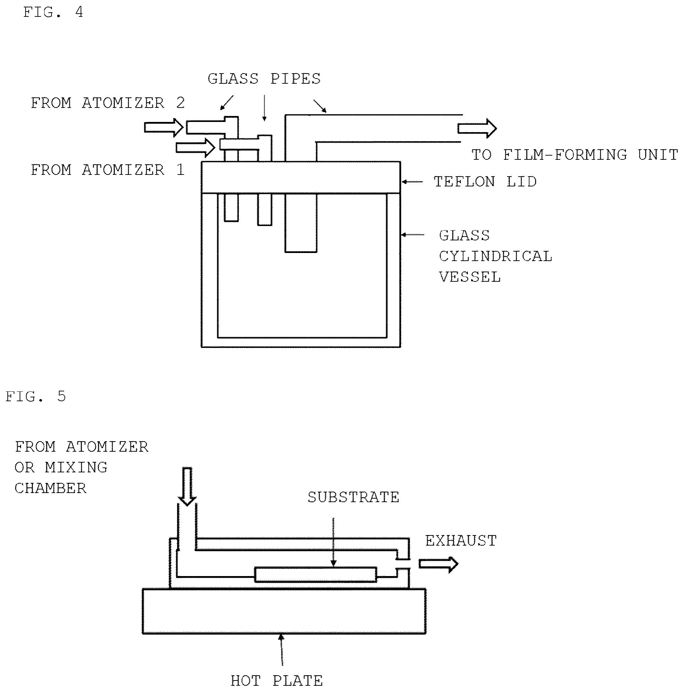

Fig. 4 illustrates a schematic view of a mixing chamber in a film-forming apparatus for a metal oxide film. The mixing chamber includes a glass vessel and a Teflon (registered trademark) lid. The lid is provided with three glass pipes penetrating therethrough. Among the three pipes, two pipes are respectively connected to two mist generators with a pipe, and one pipe provided at the center is connected to the film-forming unit with a pipe. The mist generated in the mist generator is conveyed to the film-forming unit via the mixing chamber. This mixing chamber is mainly used to mix the mist generated by separate mist generators.

Fig. 5 illustrates a schematic view of a film-forming unit in a film-forming apparatus for a metal oxide film. The film-forming unit includes a metal jig connected from the mist generator or mixing chamber, and a hot plate. The jig is connected to the mist generator mixing chamber with a silicone tube, and is provided for heating the mist and the substrate. When the heated mist passes over the substrate, a chemical reaction takes place on the substrate to form a metal oxide film. In Fig. 5, when a jig having a large internal space is used, it is possible to form a film not only on a plate-shaped substrate but also on a substrate having a three-dimensional shape. The above-described hot plate is provided for heating the jig.

The carrier gas is preferably an inert gas that does not contain oxygen at 10,000 ppm or more (volume ratio) in order to suppress oxidation of the substrate surface.

Examples of the material for the substrate include aluminum, stainless steel, zinc, copper, silicon, graphite, and glass. The shape of the substrate is not particularly limited to a plate shape and a block shape, but plate-shaped substrates such as an aluminum plate, a glass plate, a silicon wafer, and a graphite sheet are preferred.

In mCVD, it is preferable to form a metal oxide layer by subjecting the mist of the raw materials to a thermal reaction on a substrate in an atmosphere having a temperature of 200°C to 500°C, and it is still more preferable to form a metal oxide layer at 300°C to 410°C.

In the raw materials for mCVD, when the metal salt or complex is denoted as (A), the compound represented by general formula (1) is denoted as (B), and water is denoted as (C), the molar ratio ((B)/(A)) of (B) to (A) is preferably 0.01 or more and 17 or less, more preferably 0.3 or more and 10 or less, still more preferably 0.5 or more and 5 or less from the viewpoint of obtaining a metal oxide film having a low surface roughness at a high film-forming rate. From the viewpoint of the film-forming rate and the surface roughness, the molar ratio ((C)/(B)) of (C) to (B) is preferably 1 or more and 250 or less, more preferably 60 or more and 180 or less, still more preferably 100 or more and 180 or less.

In the raw materials for mCVD, from the viewpoint of obtaining a metal oxide film having a low surface roughness at a high film-forming rate, the (A) is preferably 1.7 parts by weight or more and 90 parts by weight or less, more preferably 1.7 parts by weight or more and 50 parts by weight or less, the (B) component is preferably 0.2 parts by weight or more and 65 parts by weight or less, more preferably 1.2 parts by weight or more and 65 parts by weight or less, and the (C) is preferably 5 parts by weight or more and 96 parts by weight or less in 100 parts by weight of the total weight of the (A), (B) and (C). In this case, from the viewpoint of efficiently performing film formation, the amounts of the solvents are preferably 100 parts by weight or more and 1,400 parts by weight or less, more preferably 100 parts by weight or more and 1,000 parts by weight or less, still more preferably 100 parts by weight or more and 800 parts by weight or less in total with respect to 100 parts by weight of the total weight of the (A), (B) and (C).

The metal oxide film is formed from a solution of the film-forming auxiliary agent for chemical vapor deposition and a solution of the metal salt or complex and has a thickness of 0.1 µm or more and 20 µm or less.

### EXAMPLES

Hereinafter, the present invention will be described more specifically with reference to Examples and Comparative Examples.

### <Production Example>

### <Preparation of film-forming auxiliary agent for CVD, solution of metal salt or complex, and coating solution for chemical vapor deposition>

Solutions of film-forming auxiliary agents for CVD, solutions of metal salts or complexes, and coating solutions for chemical vapor deposition were prepared using the raw materials and amounts thereof mixed presented in Tables 1 to 3.

**[Table 1]**

| Solution of metal salt or complex | A-1 | A-2 | A-3 | A-4 | A-5 |
|---|---|---|---|---|---|
| (A) Metal species or complex | Al(acac)3 | Al (acac) 3 | Al (acac) 3 | Y(acac)3 | Zr (acac) 4 |
| Solvent | Acetonitrile | Toluene | Acetonitrile | Methanol | Methanol |
| Amount (g) of metal salt or complex | 3.2 | 3.2 | 23 | 3.9 | 4.9 |
| Amount (g) of solvent | 156 | 173 | 156 | 158 | 158 |
| Solution of metal salt or complex | A-6 | A-7 | A-8 | A-9 | A-10 |
| (A) Metal species or complex | Polysilazane | Al(acac)3 | Al(acac)3 | Al(acac)3 | Al(acac)3 |
| Solvent | Acetonitrile | Acetonitrile | Methanol | Methanol : toluene = 1 : 1 | Methanol |
| Amount (g) of metal salt or complex | 2.0 | 1.7 | 56.5 | 45.1 | 15.7 |
| Amount (g) of solvent | 156 | 66 | 676 | 577 | 688 |

In Table 1, Al(acac)3 denotes aluminum tris(acetylacetonate) ("Aluminum Chelate A", manufactured by Kawaken Fine Chemicals Co., Ltd.);
Y(acac)3 denotes yttrium tris(acetylacetonate) trihydrate (manufactured by Mitsuwa Chemicals Co., Ltd.);
Zr(acac)4 denotes zirconium tetrakis(acetylacetonate) (manufactured by Tokyo Chemical Industry Co., Ltd.); and
Polysilazane denotes TRESMILE ANN120-20 (manufactured by SANWA KAGAKU CORP.).

**[Table 2]**

| Solution of film-forming auxiliary agent for CVD | B-1 | B-2 | B-3 | B-4 | B-5 | B-6 | B-7 | B-8 | B-9 | B-10 | B-11 | B-12 | B'-1 |
|---|---|---|---|---|---|---|---|---|---|---|---|---|---|
| (B) Compound represented by general formula (1) | b-1 | b-2 | b-1 | b-1 | b-3 | b-4 | b-5 | b-6 | b-7 | b-1 | b-1 | b-1 | - |
| (B') Another compound | - | - | - | - | - | - | - | - | - | - | - | - | Ethylenediamine |
| Molecular weight of B | 60.06 | 94.07 | 60.06 | 60.06 | 88.11 | 200.32 | 75.08 | 76.06 | 88.11 | 60.06 | 60.06 | 60.06 | 60.10 |
| (C) Solvent | Water | Water | Water | Water | Water | Water | Water | Water | Water | Water | Water | Water | Water |
| Molecular weight of C | 18 | 18 | 18 | 18 | 18 | 18 | 18 | 18 | 18 | 18 | 18 | 18 | 18 |
| Amount (g) of compound represented by general formula (1) | 1.9 | 3.0 | 5.8 | 9.6 | 2.8 | 6.4 | 3.6 | 2.4 | 2.2 | 0.81 | 0.52 | 0.42 | 1.9 |
| Amount (g) of solvent | 100 | 100 | 100 | 100 | 100 | 100 | 100 | 100 | 25 | 42 | 17.4 | 27.8 | 100 |
| (C)/(B) (molar ratio) | 173 | 174 | 58 | 35 | 174 | 174 | 117 | 174 | 56 | 173 | 112 | 221 | 176 |

In Table 2, b-1 denotes urea (in general formula (1), R¹ and R² are hydrogen atoms);
b-2 denotes urea (in general formula (1), R¹ and R² are hydrogen atoms) (clathrate compound with hydrogen peroxide);
b-3 denotes ethylurea (in general formula (1), R¹ is CH₃CH₂ and R² is a hydrogen atom);
b-4 denotes 1-decylurea (in general formula (1), R¹ is CH₃C₉H₁₈ and R² is a hydrogen atom);
b-5 denotes semicarbazide (in general formula (1), R¹ is an amino group and R² is a hydrogen atom);
b-6 denotes hydroxyurea (in general formula (1), R¹ is a hydroxyl group and R² is a hydrogen atom); and
b-7 denotes 1,1-dimethylurea (in general formula (1), R¹ is CH₃ and R² is CH₃).

**[Table 3]**

| Coating solution for chemical vapor deposition | D-1 | D-2 | D-3 | D-4 | D-5 |
|---|---|---|---|---|---|
| Solution of metal salt or complex | A-7 | A-7 | A-8 | A-9 | A-10 |
| Solution of film-forming auxiliary agent for CVD | B-10 | Water | B-11 | B-12 | Water |
| Others | - | Water/ 42 g | - | - | Water/ 97 g |

### <Example 1>

### <Formation of metal oxide film on substrate>

### <<Apparatus preparation>>

Using the film-forming apparatus (mist CVD apparatus) illustrated in Figs. 1 and 3 to 5, a metal oxide film was formed on a substrate by the following method. A polypropylene or tetrafluoroethylene-hexafluoropropylene copolymer film was fixed at a position 1 cm from the bottom of a glass cylinder (13 cm in diameter and 15 cm in height) with an O-ring and a caulking agent. A Teflon (registered trademark) lid was provided on the top of the cylinder, two holes were made in the lid, and glass pipes for supplying nitrogen gas and for conveying mist were inserted into the holes. The cylinder was immersed in a water bath, and three ultrasonic transducers (Ultrasonic Atomizer Unit HMC-2401; manufactured by HONDA ELECTRONICS CO., LTD.) were installed directly below the polypropylene or tetrafluoroethylene-hexafluoropropylene copolymer. The above was used as a mist generator, and two mist generators were prepared. A Teflon (registered trademark) lid was provided in a glass cylindrical vessel, three holes were made in the lid, and glass pipes for connecting the mist generator (two pipes) and for connecting the film-forming unit were inserted into the holes. The above was used as a mixing chamber, and the mixing chamber was connected to the two mist generators with a 1.5 m silicone tube. A substrate (30 × 30 × 0.5 mm, one-side polished Al plate, manufactured by TDC CO., LTD., Ra = 3 to 5 nm) was set on a hot plate in the film-forming unit. The above was used as a film-forming unit, and the film-forming unit was connected to the mixing chamber with a 1.5 m silicone tube. A solution A-1 of a metal salt or complex was injected into a mist generator 1 by 200 mL, and a solution B-1 of a film-forming auxiliary agent for CVD was injected into a mist generator 2 by 100 mL. Nitrogen gas (oxygen concentration: 1 ppm or less) was caused to flow at 11 L/min (5.5 L/min per mist generator) for 20 minutes from the nitrogen gas supply pipe of the mist generator to the exhaust hole of the film-forming unit. Thereafter, the metal material was heated with a hot plate until the temperature of the metal material reached 360°C. After it was found that the substrate temperature was stabilized at 360°C, the ultrasonic transducers of the mist generator1 and mist generator2 were operated to convert the solution of a metal salt or complex and the solution of a film-forming auxiliary agent for CVD into mist for 20 minutes, thereby forming a metal oxide film.

### <<Manufacturing conditions>>

The ultrasonic transducer was operated at a frequency of 2.4 MHz, and the supply power was set at a DC voltage of 24 V and a current of 0.6 A. The solutions of metal salts or complexes, solutions of film-forming auxiliary agents for CVD, and substrates used are presented in Table 4.

### <Examples 2 to 13 and Comparative Examples 1 to 9>

In Examples 2 to 13 and Comparative Examples 1 to 9, samples were fabricated in the same manner as in Example 1, except that the conditions for forming the metal oxide film in Example 1 were changed to the conditions (substrates, solutions of metal salts or complexes, solutions of film-forming auxiliary agents for CVD, and film-forming temperatures) presented in Tables 4 and 5. In Comparative Examples 1, 2, and 4 to 9, a film-forming auxiliary agent for CVD was not contained but only water was used.

### <Examples 14 to 16 and Comparative Examples 10 to 12>

In Example 14 and Comparative Examples 10 and 11, a solution of a metal salt or complex and a solution of a film-forming auxiliary agent for CVD were mixed in advance in the following manner to prepare a coating solution for chemical vapor deposition, and this was used for film formation.

### <Formation of metal oxide film on substrate using coating solution>

### <<Apparatus preparation>>

Using the film-forming apparatus (mist CVD apparatus) illustrated in Figs. 2, 3 and 5, a metal oxide film was formed on a substrate by the following method. A polypropylene or tetrafluoroethylene-hexafluoropropylene copolymer film was fixed at a position 1 cm from the bottom of a glass cylinder (13 cm in diameter and 15 cm in height) with an O-ring and a caulking agent. A Teflon (registered trademark) lid was provided on the top of the cylinder, two holes were made in the lid, and glass pipes for supplying nitrogen gas and for conveying mist were inserted into the holes. The cylinder was immersed in a water bath, and three ultrasonic transducers (Ultrasonic Atomizer Unit HMC-2401; manufactured by HONDA ELECTRONICS CO., LTD.) were installed directly below the polypropylene or tetrafluoroethylene-hexafluoropropylene copolymer. The above was used as a mist generator, and one mist generator was prepared. A substrate (30 × 30 × 0.5 mm) was set on a hot plate in the film-forming unit. The above was used as a film-forming unit, and the film-forming unit was connected to the mist generator with a 1.5 m silicone tube. A coating solution D-1 was injected into the mist generator by 200 mL, and nitrogen gas (oxygen concentration: 1 ppm or less) was caused to flow at 5.5 L/min for 20 minutes from the nitrogen gas supply pipe of the mist generator to the exhaust hole of the film-forming unit. Thereafter, the metal material was heated with a hot plate until the temperature of the metal material reached 360°C. After it was found that the temperature of the metal material was stabilized at 360°C, the ultrasonic transducer of the mist generator was operated to convert the coating solution into mist for 20 minutes, thereby forming a metal oxide film.

### <<Manufacturing conditions>>

The ultrasonic transducer was operated at a frequency of 2.4 MHz, and the supply power was set at a DC voltage of 24 V and a current of 0.6 A. The coating solutions and substrates used are presented in Table 6.

The samples obtained above were evaluated as follows. The results are presented in Tables 4 to 6.

### <Measurement of thickness of metal oxide film>

The thickness of the metal oxide film was measured using a reflectance spectroscopic film thickness meter (F20; manufactured by Filmetrics, INC.) after each metal oxide film was formed on chromium glass instead of the metal material in Example 1. It was assumed that the metal oxide film formed on the chromium glass and the metal oxide film formed on the metal substrate had the same thickness. In order to obtain an accurate film thickness, it is necessary to calculate the film thickness based on the data of the refractive index. As for the refractive index, the same sample was observed using an ellipsometer (UVISEL Plus; (manufactured by HORIBA, Ltd.) and the refractive index was calculated in advance.

### <Evaluation of film-forming rate improving effect>

The value acquired by dividing the film thickness (µm) acquired from the film thickness measurement by the time (min) required for film formation was taken as the film-forming rate, the relative film-forming rate was calculated based on the film-forming rate of a system not containing the compound represented by general formula (1), and the film-forming rate improving effect was evaluated as "⊙" when this relative film-forming rate was 2 or more, as "○" when this relative film-forming rate was less than 2 and 1.5 or more, as "△" when this relative film-forming rate was less than 1.5 and 1.1 or more, and as "×" when this relative film-forming rate was less than 1.1. Examples 1 to 10 and Comparative Examples 2 and 3 were evaluated based on Comparative Example 1 (for example, film-forming rate of Example 1/film-forming rate of Comparative Example 1), Example 11 and Comparative Example 5 were evaluated based on Comparative Example 4, Example 12 and Comparative Example 7 were evaluated based on Comparative Example 6, Example 13 and Comparative Example 9 were evaluated based on Comparative Example 8, and Example 14 and Comparative Example 11 were evaluated based on Comparative Example 10. Examples 15 and 16 were evaluated based on Comparative Example 12.

### <Evaluation of film surface roughness reducing effect>

The surface roughness (Ra) (unit: Å) of the metal oxide film was measured using a contact-type surface roughness meter (DektakXT-S; manufactured by Bruker Japan K.K.). The center of the substrate was measured at 0.5 mm, and the surface roughness (arithmetic mean roughness) and standard deviation of the surface roughness were calculated. From these values, the surface roughness ratio and the standard deviation ratio of the surface roughness were calculated based on the values (surface roughness and standard deviation of surface roughness) of a system not containing the compound represented by general formula (1), and the film surface roughness reducing effect was evaluated as "⊙" when the surface roughness ratio was less than 0.8, as "○" when the surface roughness ratio was 0.8 or more and less than 1.0, as "△" when the surface roughness ratio was 1.0 or more and less than 1.2, and as "×" when the surface roughness ratio was 1.2 or more. The standard deviation of the surface roughness was also evaluated according to the criteria. Examples 1 to 10 and Comparative Examples 2 and 3 were evaluated based on Comparative Example 1 (for example, surface roughness of Example 1/surface roughness of Comparative Example 1), Example 11 and Comparative Example 5 were evaluated based on Comparative Example 4, Example 12 and Comparative Example 7 were evaluated based on Comparative Example 6, Example 13 and Comparative Example 9 were evaluated based on Comparative Example 8, and Example 14 and Comparative Example 11 were evaluated based on Comparative Example 10. Examples 15 and 16 were evaluated based on Comparative Example 12.

For reference, the surface roughness (Å)/film thickness (µm) and the standard deviation of surface roughness/film thickness (µm) are presented in Tables 4 to 6.

**[Table 4]**

| | | Example 1 | Example 2 | Example 3 | Example 4 | Example 5 | Example 6 | Example 7 | Example 8 | Example 9 | Example 10 | Comparative Example 1 | Comparative Example 2 | Comparative Example 3 |
|---|---|---|---|---|---|---|---|---|---|---|---|---|---|---|
| Substrate | | Al | Al | Al | Al | Al | Al | Al | Al | Al | Al | Al | Al | Al |
| Film-forming temperature (°C) | | 360 | 360 | 360 | 360 | 360 | 360 | 360 | 360 | 360 | 360 | 360 | 410 | 360 |
| Solution of metal salt or complex | Kind | A-1 | A-1 | A-1 | A-1 | A-2 | A-3 | A-1 | A-2 | A-1 | A-1 | A-1 | A-1 | A-1 |
| | Weight (g) | 159 | 159 | 159 | 159 | 176 | 179 | 159 | 176 | 159 | 159 | 159 | 159 | 159 |
| | Weight (g) of (A) metal salt or complex | 3.2 | 3.2 | 3.2 | 3.2 | 3.2 | 2.3 | 3.2 | 3.2 | 3.2 | 3.2 | 3.2 | 3.2 | 3.2 |
| | Molecular weight of (A) | 324.3 | 324.3 | 324.3 | 324.3 | 324.3 | 324.3 | 324.3 | 324.3 | 324.3 | 324.3 | 324.3 | 324.3 | 324.3 |
| Film-forming auxiliary agent for chemical vapor deposition | Kind | B-1 | B-2 | B-3 | B-4 | B-1 | B-1 | B-5 | B-6 | B-7 | B-8 | Water | Water | B'-1 |
| | Weight (g) | 102 | 103 | 106 | 110 | 102 | 102 | 103 | 106 | 104 | 102 | 100 | 100 | 102 |
| | Weight (g) of (B) compound represented by general formula (1) | 1.9 | 3.0 | 5.8 | 9.6 | 1.9 | 1.9 | 2.8 | 6.4 | 3.6 | 2.4 | 0 | 0 | 1.9 |
| | Molecular weight of (B) | 60.06 | 94.07 | 60.06 | 60.06 | 60.06 | 60.06 | 88.11 | 200.32 | 75.08 | 76.06 | - | - | 60.10 |
| (B)/(A) (molar ratio) | | 3.2 | 3.2 | 9.7 | 16.2 | 3.2 | 4.5 | 3.2 | 3.2 | 4.8 | 3.2 | - | - | 3.2 |
| | Metal oxide film thickness (µm) | 0.94 | 1.00 | 1.2 | 1.8 | 1.01 | 3.8 | 0.97 | 0.86 | 0.99 | 1.02 | 0.42 | 0.50 | 0.40 |
| | Film-forming rate (µm/min) | 0.047 | 0.050 | 0.059 | 0.088 | 0.051 | 0.19 | 0.048 | 0.043 | 0.050 | 0.051 | 0. 021 | 0.025 | 0.020 |
| | Surface roughness (A) / film thickness (µm) | 79 | 90 | 90 | 91 | 91 | 90 | 93 | 94 | 93 | 95 | 108 | 144 | 130 |
| | Relative value to Comparative Example 1 | 0.7 | 0.8 | 0.8 | 0.8 | 0.8 | 0.8 | 0.9 | 0.9 | 0.9 | 0.9 | 1.0 | 1.3 | 1.2 |
| Evaluation | Standard deviation of surface roughness (Å) / film thickness (µm) | 4.3 | 5.5 | 5.5 | 5.6 | 5.6 | 5.5 | 5.6 | 5.6 | 5.5 | 5.6 | 12 | 33 | 20 |
| | Relative value to Comparative Example 1 | 0.4 | 0.5 | 0.5 | 0.5 | 0.5 | 0.5 | 0.5 | 0.5 | 0.5 | 0.5 | 1.0 | 2.7 | 1.7 |
| | Evaluation of film-forming rate improving effect | ⊙ | ⊙ | ⊙ | ⊙ | ⊙ | ⊙ | ○ | ○ | ○ | ○ | - | Δ | × |
| | Evaluation of film surface roughness reducing effect | ⊙ | ○ | ○ | ○ | ○ | ○ | ○ | ○ | ○ | ○ | - | × | × |
| | Evaluation of film surface roughness reducing effect (standard deviation) | ⊙ | ⊙ | ⊙ | ⊙ | ⊙ | ⊙ | ⊙ | ⊙ | ⊙ | ⊙ | - | × | × |

**[Table 5]**

| | | Example 11 | Comparative Example 4 | Comparative Example 5 | Example 12 | Comparative Example 6 | Comparative Example 7 | Example 13 | Comparative Example 8 | Comparative Example 9 |
|---|---|---|---|---|---|---|---|---|---|---|
| Substrate | | Al | Al | Al | Al | Al | Al | Al | Al | Al |
| Film-forming temperature (°C) | | 360 | 360 | 410 | 360 | 360 | 410 | 300 | 300 | 360 |
| Solution of metal salt or complex | Kind | A-4 | A-4 | A-4 | A-5 | A-5 | A-5 | A-6 | A-6 | A-6 |
| | Weight (g) | 162 | 162 | 162 | 163 | 163 | 163 | 158 | 158 | 158 |
| | Weight (g) of (A) metal salt or complex | 3.9 | 4.9 | 5.9 | 2.0 | 2.0 | 2.0 | 1.7 | 1.7 | 1.7 |
| | Molecular weight of (A) | 440.3 | 440.3 | 440.3 | 487.66 | 487.66 | 487.66 | 41.0 | 41.0 | 41.0 |
| Film-forming auxiliary agent for chemical vapor deposition | Kind | B-1 | Water | Water | B-1 | Water | Water | B-9 | Water | Water |
| | Weight (g) | 102 | 100 | 100 | 102 | 100 | 100 | 100 | 100 | 100 |
| | Weight (g) of (B) compound represented by general formula (1) | 1.9 | 0 | 0 | 1.9 | 0 | 0 | 2.2 | 0 | 0 |
| | Molecular weight of (B) | 60.06 | - | - | 60.06 | - | - | 88.11 | - | - |
| (B) /(A) (molar ratio) | | 3.6 | - | - | 7.7 | - | - | 0.6 | - | - |
| | Metal oxide film thickness (µm) | 1.3 | 0.62 | 0.73 | 0.40 | 0.23 | 0.26 | 0.55 | 0.23 | 0.29 |
| | Film-forming rate (µm/min) | 0.065 | 0.031 | 0.036 | 0.024 | 0.011 | 0.013 | 0.055 | 0.023 | 0.029 |
| | Surface roughness (Å) / film thickness (µm) | 75 | 76 | 91 | 160 | 166 | 212 | 262 | 265 | 332 |
| | Relative value to Comparative Examples 4, 6, or 8 | 1.0 | 1.0 | 1.2 | 1.0 | 1.0 | 1.3 | 1.0 | 1.0 | 1.3 |
| Evaluation | Standard deviation of surface roughness (Å) / film thickness (µm) | 6.7 | 7.6 | 16 | 17 | 19 | 58 | 73 | 87 | 174 |
| | Relative value to Comparative Examples 4, 6, or 8 | 0.9 | 1.0 | 2.2 | 0.9 | 1.0 | 3.1 | 0.8 | 1.0 | 2.0 |
| | Evaluation of film-forming rate improving effect | ⊙ | - | Δ | ⊙ | - | Δ | ⊙ | - | Δ |
| | Evaluation of film surface roughness reducing effect | ○ | - | × | ○ | - | × | ○ | - | × |
| | Evaluation of film surface roughness reducing effect (standard deviation) | ○ | - | × | ○ | - | × | ○ | - | × |

**[Table 6]**

| | | Example 14 | Comparative Example 10 | Comparative Example 11 | Example 15 | Example 16 | Comparative Example 12 |
|---|---|---|---|---|---|---|---|
| Substrate | | Al | Al | Al | Al | Al | Al |
| Film-forming temperature (°C) | | 360 | 360 | 410 | 360 | 360 | 360 |
| Coating solution for chemical vapor deposition | Kind | D-1 | D-2 | D-2 | D-3 | D-4 | D-5 |
| | Weight (g) | 111 | 110 | 110 | 750 | 650 | 800 |
| | Weight (g) of (A) metal salt or complex | 1.7 | 1.7 | 1.7 | 56.5 | 45.1 | 15.65 |
| | Weight (g) of (B) compound represented by general formula (1) | 0.81 | - | - | 0.52 | 0.42 | - |
| | Weight (g) of (C) water | 42 | 42 | 42 | 17.4 | 27.8 | 96.52 |
| | (B) / (A) (molar ratio) | 2.57 | - | - | 0.05 | 0.05 | - |
| | (C) / (B) (molar ratio) | 173 | - | - | 112 | 221 | - |
| | Metal oxide film thickness (µm) | 0.84 | 0.40 | 0.48 | 1.9 | 1.2 | 0.54 |
| | Film-forming rate (µm/min) | 0.042 | 0.020 | 0.024 | 0.095 | 0.060 | 0.027 |
| | Surface roughness (Å) / film thickness (µm) | 85 | 107 | 137 | 90 | 91 | 144 |
| | Relative value to Comparative Examples 10 or 12 | 0.8 | 1.0 | 1.3 | 0.6 | 0.6 | 1.0 |
| Evaluation | Standard deviation of surface roughness (Å) / film thickness (µm) | 4.6 | 5.5 | 24 | 5.5 | 5.6 | 33 |
| | Relative value to Comparative Examples 10 or 12 | 0.8 | 1.0 | 4.3 | 0.2 | 0.2 | 1.0 |
| | Evaluation of film-forming rate improving effect | ⊙ | - | Δ | ⊙ | ⊙ | - |
| | Evaluation of film surface roughness reducing effect | ⊙ | - | × | ⊙ | ⊙ | - |
| | Evaluation of film surface roughness reducing effect (standard deviation) | ○ | - | × | ⊙ | ⊙ | - |

In Examples 1 to 10, the compound represented by general formula (1) was added and film formation was performed, and thus the film-forming rate was improved and the surface roughness was more favorable compared with those in Comparative Example 1 in which this compound was not contained. This was due to the effect of the film-forming auxiliary agent for CVD containing the compound represented by general formula (1). In Examples 3 and 4, film formation was performed using a film-forming auxiliary agent for CVD having a higher concentration of the compound represented by general formula (1) than in Example 1. In Example 5, the metal oxide film was formed by changing the kind of solvent, but the film-forming rate was similar to that in Example 1. In Example 6, the metal oxide film was formed using a solution having a high concentration of a metal salt or complex in the solution of a metal salt or complex, but the film-forming rate was similar to that in Example 1. In Examples 7 to 10, film formation was performed using compounds represented by general formula (1) with various structures, and the film-forming rate and surface roughness were favorable as in Example 1.

In Comparative Example 2, in which film formation was performed at a higher temperature than in Comparative Example 1, the film-forming rate was slightly improved but the surface roughness became poorer. In Comparative Example 3, in which ethylenediamine was used as the film-forming auxiliary agent for CVD, the film-forming rate and surface roughness became poorer.

In Examples 11 to 13, the compound represented by general formula (1) was added and film formation was performed, and the film-forming rate was improved and the surface roughness was more favorable compared with those in Comparative Examples 4, 6, and 8 in which this compound was not contained. In Comparative Examples 5, 7, and 9, in which film formation was performed at a higher temperature than in Comparative Examples 4, 6, and 8, the film-forming rate was slightly improved but the surface roughness became poorer.

In Example 14, film formation was performed using a coating solution for chemical vapor deposition, which contained a solution of a film-forming auxiliary agent for chemical vapor deposition containing the compound represented by general formula (1) and a solution of a metal salt or complex, and thus the film-forming rate was improved and the surface roughness was more favorable compared with those in Comparative Example 10 in which the compound represented by general formula (1) was not contained. In Comparative Example 11, in which film formation was performed at a higher temperature than in Comparative Example 10, the film-forming rate was slightly improved but the surface roughness was poorer.

In Examples 15 and 16, film formation was performed using a coating solution for chemical vapor deposition, which contained a solution of a film-forming auxiliary agent for chemical vapor deposition containing the compound represented by general formula (1) and a solution of a metal salt or complex, and thus the film-forming rate was improved and the surface roughness was more favorable compared with those in Comparative Example 12 in which the compound represented by general formula (1) was not contained.

## Claims

1. A film-forming auxiliary agent for chemical vapor deposition, comprising a compound represented by general formula (1): R¹R²NCONH₂ (in the formula, R¹ and R² each independently represent a hydrogen atom, a hydrocarbon group having 1 to 22 carbon atoms, an amino group, or a hydroxyl group).

2. A coating solution for chemical vapor deposition, comprising a solution of the film-forming auxiliary agent for chemical vapor deposition according to claim 1 and a solution of a metal salt or complex.

3. A metal oxide film having a thickness of 0.1 µm or more and 20 µm or less, which is formed from a solution of the film-forming auxiliary agent for chemical vapor deposition according to claim 1 and a solution of a metal salt or complex.

4. A film-forming method for a metal oxide film, the method comprising:
a step (a1) of separately converting a solution of the film-forming auxiliary agent for chemical vapor deposition according to claim 1 into mist and a solution of a metal salt or complex into mist; and
a step (b1) of simultaneously supplying each mist to a heated substrate surface.

5. A film-forming method for a metal oxide film, the method comprising:
a step (a2) of converting the coating solution for chemical vapor deposition according to claim 2 into mist; and
a step (b2) of supplying the obtained mist to a heated substrate surface.
